# EUROPEAN PATENT SPECIFICATION

(11) **EP 3 483 987 B1**
(45) Date of publication and mention of the grant of the patent: **20.10.2021**
(21) Application number: 17833277.1
(22) Date of filing: 27.04.2017
(51) Int. Cl.: H01R 12/72, H01R 107/00, H01R 24/62, H01R 12/70, H05K 1/18, H01R 13/6585

(54) **POWER INTERFACE, MOBILE TERMINAL, AND POWER ADAPTER**
STROMSCHNITTSTELLE, MOBILES ENDGERÄT UND NETZTEIL
INTERFACE D'ALIMENTATION, TERMINAL MOBILE ET ADAPTATEUR D'ALIMENTATION

(30) Priority: 27.07.2016 CN 201620806997 U
(43) Date of publication of application: 15.05.2019
(73) Proprietor: GUANGDONG OPPO MOBILE TELECOMMUNICATIONS CORP., LTD., Wusha, Chang'an Dongguan, Guangdong 523860 (CN)
(72) Inventor: GU, Guodong, Dongguan Guangdong 523860 (CN)
(74) Representative: Manitz Finsterwald Patent- und Rechtsanwaltspartnerschaft mbB
(86) International application number: PCT/CN2017/082259
(87) International publication number: WO 2018/018971

(56) References cited:
- EP-A1- 2 988 376
- WO-A1-2015/113340
- CN-A- 104 064 910
- CN-A- 104 505 678
- CN-A- 104 882 696
- CN-A- 105 356 097
- CN-A- 105 356 097
- CN-A- 105 703 157
- CN-A- 106 025 615
- CN-A- 106 252 924
- CN-U- 204 732 558
- CN-U- 205 178 096
- CN-U- 205 882 229
- US-A1- 2001 046 354
- US-A1- 2015 255 925
- US-B1- 9 231 356

## Description

### TECHNICAL FIELD

The described embodiments relate to communication technology, and in particular to a power interface, a mobile terminal, and a power adapter.

### BACKGROUND

With the continuous improvement of living conditions, mobile phones have become essential communication tools for people. In order to meet the requirements of users and improve the market competitiveness of the mobile phones, on one hand, researchers and developers continue to improve the performance of mobile phones; on the other hand, researchers and developers continue to improve and optimize the appearance of mobile phones. Charging sockets are important components for the mobile phones. On one hand, when charging the mobile phones, the mobile phones need to be charged via the charging sockets; on the other hand, it is possible to achieve data transmission between the mobile phones and other devices by means of the charging sockets.

EP 2988376 A1 discloses a connector comprising: a first insulator substrate; a first contact configured by arranging a plurality of contact pins including contact pins for differential signals as an array, on a top surface of the first insulator substrate; a second insulator substrate; a second contact configured by arranging a plurality of contact pins including contact pins for differential signals as an array in the same direction as the array direction of the first contact, on an undersurface of the second insulator substrate; and a metal plate sandwiched by an undersurface of the first insulator substrate and a top surface of the second insulator substrate; wherein the contact pins for differential signals of the first contact and the contact pins for differential signals of the second contact are arrayed in the same order so as to face each other; and one or more holes in an arbitrary shape and with a size smaller than a circle having a diameter corresponding to one-fourth of the wavelength of the differential signals are formed in an area on the metal plate, the area being sandwiched by the contact pins for differential signals of the first and second contacts facing each other.

US 9231356 B1 discloses an electrical connector includes a body having a tongue, a row of first terminals insert-molded in the body, a depressed slot, and a positioning slot. The tongue includes a first surface having multiple receiving slots. Each first terminal has a contact portion accommodated in the receiving slot and exposed from the first surface. The first terminals include a pair of differential signal terminals and multiple non-high-speed terminals. The depressed slot is depressed from the first surface, located between contact portions of two differential signal terminals, and in communication with two adjacent receiving slots. The positioning slot is depressed from the first surface, located between contact portions of two adjacent non-high-speed terminals, or of adjacent non-high-speed terminal and differential signal terminal, and in communication with two adjacent receiving slots. The length of the positioning slot is less than the length of the depressed slot.

US 2015/255925 A1 discloses a connector, which is mateable with a mating connector along a mating direction. The connector comprises a housing, a plurality of first contacts, a plurality of second contacts and a ground plate. The housing has a plate-like portion extending in a predetermined plane which is defined by the mating direction and a pitch direction perpendicular to the mating direction. The plate-like portion has a first principal surface and a second principal surface which is opposite to the first principal surface in a predetermined direction perpendicular to both the mating direction and the pitch direction. The first contacts are held by the housing. The first contacts have first contact portions, respectively. The second contacts are held by the housing. The second contacts have second contact portions, respectively. The ground plate includes a main portion. The main portion is formed with a plurality of openings. Each of the openings pierces the main portion in the predetermined direction and has a closed periphery in the predetermined plane. The main portion is embedded in the plate-like portion by insert molding. The main portion is positioned between the first contact portions and the second contact portions in the predetermine direction.

WO 2015/113340 A1 discloses a USB interface and a mobile terminal comprising the USB interface. The mobile terminal is capable of driving other mobile terminals through the USB interface. The USB interface comprises: a USB interface body (1), a power line plug (3) externally connected to power lines through insertion parts, and a ground line plug (7) externally connected to ground lines through insertion parts. The edge of a bottom (32) of the power line plug and the edge of a bottom (72) of the ground line plug are fixed to the USB interface body. The power line plug has P insertion parts, and P is greater than or equal to 2; the ground line plug has Q insertion parts, and Q is greater than or equal to 2. The USB interface supports charging with a current greater than 3 amperes.

CN 105703157 A discloses an electric connector, and the connector comprises an insulating body and first terminals. Each first terminal comprises a central part fixed on the insulating body, a contact part extending from the central part, and a pin extending from the central part, wherein the pin comprises a connection part extending from the central part, and a welding part extending from the connection part to be installed on a circuit board. The first terminals at least comprise two grounding/power terminals and a pair of differential pair terminals disposed between the two grounding/power terminals. The contact parts of the first terminals are arranged in a row. The welding parts of the differential pair terminals are arranged in a first row, and the welding part of the two grounding/power terminals are arranged in a second row, wherein the first row and the second row are parallel to each other. The connection parts of the two grounding/power terminals are provide with ghost segments which are arranged in the same row as the connection parts of the differential pair terminals. Compared with the prior art, the connector can shield the differential pair terminals to maximum degree through setting the pins of the grounding/power terminals in a segmented manner, and improves the high-frequency performances.

CN 105356097 A discloses an electric connector, and the connector comprises an insulating body and first terminals. Each first terminal comprises a central part fixed on the insulating body, a contact part extending from the central part, and a pin extending from the central part, wherein the pin comprises a connection part extending from the central part, and a welding part extending from the connection part to be installed on a circuit board. The first terminals at least comprise two grounding/power terminals and a pair of differential pair terminals disposed between the two grounding/power terminals. The contact parts of the first terminals are arranged in a row. The welding parts of the differential pair terminals are arranged in a first row, and the welding part of the two grounding/power terminals are arranged in a second row, wherein the first row and the second row are parallel to each other. The connection parts of the two grounding/power terminals are provide with ghost segments which are arranged in the same row as the connection parts of the differential pair terminals. Compared with the prior art, the connector can shield the differential pair terminals to maximum degree through setting the pins of the grounding/power terminals in a segmented manner, and improves the high-frequency performances.

### SUMMARY OF THE DISCLOSURE

The present disclosure aims to solve at least one of the technical problems in the related art at least to some extent. The invention is defined by the independent claim 1. The present disclosure provides a power interface having the advantage of high reliability.

The present disclosure further provides a mobile terminal including the power interface mentioned above.

The present disclosure further provides a power adapter including the power interface mentioned above.

Claim 1 discloses a power interface according to the invention.

The power interface of the embodiments of the present disclosure, by arranging the intermediate patch between the two sub pins which are spaced apart from each other in the up-down direction, it is possible to support the sub pins, and avoid poor contact between a connecting line and the power interface caused by the movement of the two sub pins which are spaced apart from each other in the up-down direction towards each other when the connection line is inserted into the power interface. In this way, it is possible to ensure the reliability of the connection between the connection line and the power interface. In addition, the intermediate patch defining the through hole and the reinforcing rib arranged in the through hole could not only save the material of the intermediate patch, but also improve the structural strength of the intermediate patch. A recess is defined in the expanded portion at a position that is close to the front end of the power pin. It should be noted that, when the power interface performs the fast charging function, the power pin with the expanded portion may be used to carry a large charging current. When the power interface performs the normal charging function, the recess defined in the expanded portion may prevent the sub-pin from getting into contact with a corresponding pin of a power adapter. In this way, the power interface in this embodiment may be applied to different power adapters.

The mobile terminal according to embodiments of the present disclosure may include the power interface mentioned above.

The power adapter according to embodiments of the present disclosure may include the power interface mentioned above.

### BRIEF DESCRIPTION OF THE DRAWINGS

FIG. 1 is an exploded view of a power interface according to an embodiment of the present disclosure.
FIG. 2 is a partially enlarged view of circle A in FIG 1.
FIG. 3 is a structural view of a intermediate patch in the power interface according to some embodiments of the present disclosure.
FIG. 4 is a cutaway view of the power interface according to some embodiments of the present disclosure.
FIG. 5 is a cutaway view of the power interface viewing in another angle according to some embodiments of the present disclosure.
FIG. 6 is a cutaway view of the power interface viewing in yet another angle according to some embodiments of the present disclosure.
FIG. 7 is a cutaway view of the power interface viewing in a further angle according to some embodiments of the present disclosure.
FIG. 8 is a partially enlarged view of circle B in FIG. 7.
FIG. 9 is a cutaway view of the power interface viewing in still a further angle according to some embodiments of the present disclosure.
FIG. 10 is a partially enlarged view of circle C in FIG. 9.
FIG. 11 is a structural view of a power source pin according to some embodiments of the present disclosure.

### List of reference numbers in drawings:

power interface 100,
plug shell 1, first stopping plate 11, stopping protrusion 111,
plug body 2, power source pin 21, sub-pin 211, expanded portion 2111, and recess 2112,
data pin 22,
intermediate patch 23, hollowed-out parts 231, reinforcing rib 232, reinforcing protrusion 233, notch 234, crimping 235, widened portion 236,
encapsulation member 24, first encapsulation portion 241, embedding protrusion 2411,
second encapsulation portion 242, receiving groove 2421, engaging flange 2422,
engaging groove 2423,
circuit board 25, first pad 251, second pad 252,
second stopping plate 3, gap 31.

### DETAILED DESCRIPTION

Embodiments of the present disclosure will be described in detail below, and examples of the embodiments will be illustrated in the accompanying drawings. The embodiments described below with reference to the drawings are illustrative and are intended to explain the present disclosure, and cannot be construed as a limitation to the present disclosure.

In the description of the present disclosure, it is to be understood that terms such as "top", "bottom", "front", "rear", "left", "right", "inner", "outer", "circumference", and the like, refer to the orientations and locational relations illustrated in the accompanying drawings. Thus, these terms used here are only for describing the present disclosure and for describing in a simple manner, and are not intended to indicate or imply that the device or the elements are arranged to locate at the specific directions or are structured and performed in the specific directions, which could not to be understood as limiting the present disclosure.

In addition, terms such as "first", "second", and the like are used herein for purposes of description, and are not intended to indicate or imply relative importance or significance or to imply the number of indicated technical features. Thus, the feature defined with "first", "second", and the like may include one or more of such a feature. In the description of the present disclosure, "a plurality of" means two or more, such as two, three, and the like, unless specified otherwise.

In the present disclosure, unless specified or limited, otherwise, terms "mounted", "connected", "coupled", "fixed", and the like are used in a broad sense, and may include, for example, fixed connections, detachable connections, or integral connections; may also be mechanical or electrical connections; may also be direct connections or indirect connections via intervening structures; may also be inner communications of two elements, as can be understood by one skilled in the art depending on specific contexts.

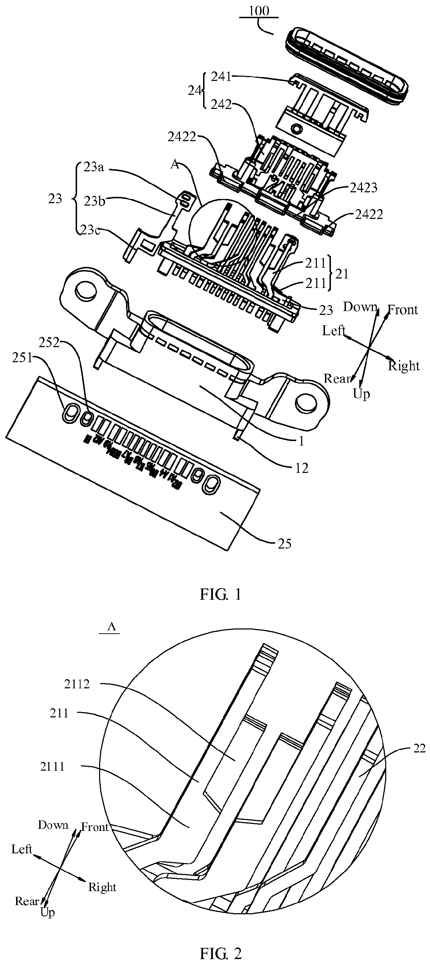

In the following, a power interface 100 may be will be described in embodiments of the present disclosure with reference to FIGS. 1-11. It should be understood that, the power interface 100 may include an interface configured for charging or data transmission, and may be arranged in a mobile terminal such as a mobile phone, a tablet computer, a laptop, or any other suitable mobile terminal having a rechargeable function. The power interface 100 may be electrically connected to a corresponding power adapter to achieve a communication of electrical signals and data signals.

Referring to FIGS. 1-11, the power interface 100 according to an embodiment of the present disclosure may include a plug shell 1, a plug body 2, and a intermediate patch 23.

More specifically, the plug body 2 may be arranged in the plug shell 1. The plug body 2 may be configured to be connected to a circuit board 25, and may include at least a pair of power source pins 21. In this embodiment, each pair of power source pins may include two power source sub-pins 211 spaced apart from each other in up-down direction (the up-down direction as shown in FIG. 1). The intermediate patch 23 may be sandwiched between the two power source sub-pins 211. The intermediate patch 23 may have a head end close to a front end of the power source pin 21 (the front end as shown in FIG 1) and a tail end close to a rear end of the power source pin 21 (the rear end as shown in FIG. 1). The head end may define a hollowed-out parts 231, and a reinforcing rib 232 may be arranged in the hollowed-out parts 231. The intermediate patch 23 may be configured to support the power source sub-pins 211. Therefore, it is possible to avoid poor contact between a connecting line and the power interface 100 caused by the movement of the two power source sub-pins 211 which are spaced apart from each other in the up-down direction towards each other when the connection line is inserted into the power interface. In this way, it is possible to ensure the reliability of the connection between the connection line and the power interface 100.

In addition, the intermediate patch 23 defines the hollowed-out parts 231, so as to save the material of the intermediate patch 23. The reinforcing rib 232 arranged in the hollowed-out parts 231 could improve the structural strength of the intermediate patch 23.

It should be noted that, the power interface 100 may be arranged on a mobile terminal, and a battery can be arranged inside the mobile terminal (e.g., a mobile phone, a tablet computer, a notebook computer, etc.). The battery may be charged by an external power source via the power interface 100.

In the power interface 100 of the embodiment of the present disclosure, by arranging the intermediate patch 23 between the two power source sub-pins 211 which are spaced apart from each other in the up-down direction, it is possible to support the power source sub-pins 211, and avoid poor contact between a connecting line and the power interface 100 caused by the movement of the two power source sub-pins 211 which are spaced apart from each other in the up-down direction towards each other when the connection line is inserted into the power interface. In this way, it is possible to ensure the reliability of the connection between the connection line and the power interface 100. In addition, the intermediate patch 23 defines the hollowed-out parts 231 and the reinforcing rib 232 arranged in the hollowed-out parts 231 could not only save the material of the intermediate patch 23, but also improve the structural strength of the intermediate patch 23.

In some embodiments of the present disclosure, as shown in FIG. 2, at least one sub-pin 211 may include an expanded portion 2111. The expanded portion 2111 may have a cross-sectional area larger than that of a data pin 22 of the plug body 2. In this way, the current load of the power source sub-pins 211 may be increased, and the transmission speed of the current may be improve. In this way, the power interface 100 may have a fast charging function, thereby improving the charging efficiency of the battery.

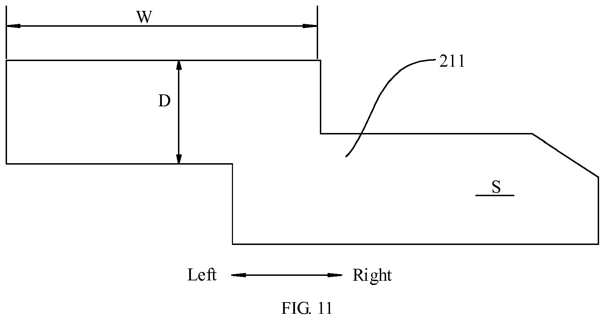

Optionally, as shown in FIG. 11, the cross-sectional area of the expanded portion 2111 may be defined as S, and S ≥ 0.09805 mm². It has been experimentally verified that when S ≥ 0.09805 mm², the current load of the power source sub-pins 211 may be at least 10A. Therefore, the charging efficiency can be improved by increasing the current load of the power source sub-pins 211. After further tests, when S=0.13125 mm², the current load of the power source sub-pins 211 may be 12A or more, which can improve charging efficiency.

Furthermore, as shown in FIG. 11, a thickness of the sub-pin 211 may be defined as D, and 0.1 mm ≤ D ≤ 0.3 mm. It has been experimentally verified that when 0.1 mm ≤ D ≤ 0.3 mm, the current load of the power source sub-pins 211 is at least 10A. In this way, it is possible to improve the charging efficiency by increasing the current load of the power source sub-pins 211. After further tests, when D=0.25mm, the current load of the power source sub-pins 211 may be greatly increased, and the current load of the power source sub-pins 211 is 12A or more, thereby improving the charging efficiency.

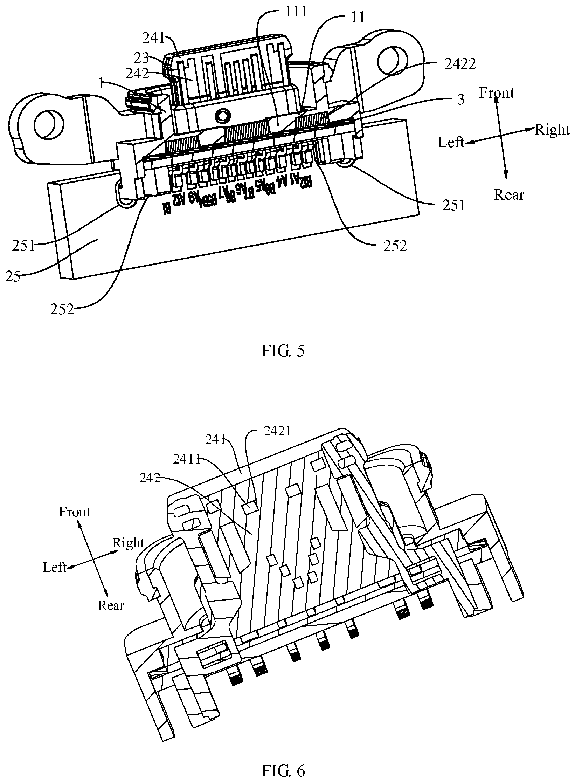

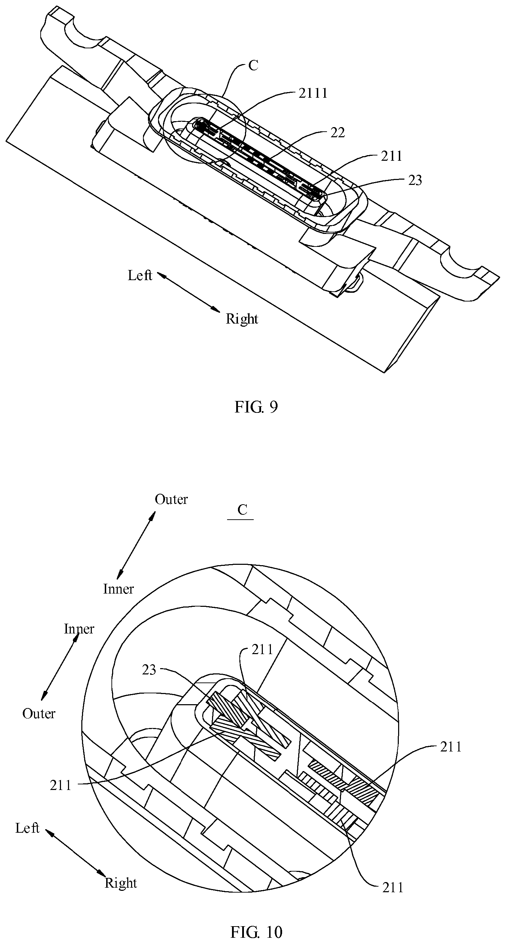

Referring to FIGS. 9-11, each sub-pin 211 may have a contact face configured to be electrically connected to the power adapter. In a width direction of the sub-pin 211 (i.e. the left-right direction shown in FIG. 6), a width of the contact face may be defined as W, which meets 0.24 mm ≤ W ≤ 0.32 mm. It has been experimentally verified that when 0.24 mm ≤ W ≤ 0.32 mm, the current load of the sub-pin 211 is at least 10 A. In this way, it is possible to improve the charging efficiency by increasing the current load of the power source sub-pins 211. After further tests, when W = 0.25 mm, the current load of the sub-pin 211 may be greatly increased, and the current load of the power source sub-pins 211 is 12A or more, thereby improving the charging efficiency.

According to some embodiments of the present disclosure, referring to FIG. 2, the expanded portion 2111 may be located in the middle of the sub-pin 211. In this way, the arrangement of the power source sub-pins 211 and the data pins 22 may be optimized, and the space of the power interface 100 may be fully utilized. Therefore, the compactness and the rationality of the configuration of the power interface 100 may be improved.

Furthermore, as shown in FIG. 2, a recess 2112 may be defined in the expanded portion 2111 at a position that is close to the front end of the sub-pin 211. It should be noted that, when the power interface 100 performs the fast charging function, the sub-pin 211 with the expanded portion 2111 may be used to carry a large charging current. When the power interface 100 performs the normal charging function, the recess 2112 defined in the expanded portion 2111 may prevent the sub-pin 211 from getting into contact with a corresponding pin of a power adapter. In this way, the power interface 100 in this embodiment may be applied to different power adapters. For example, when the power interface 100 performs the fast charging function, the power interface 100 may be electrically connected to a corresponding power adapter with the fast charging function. When the power interface 100 performs the normal charging function, the power interface 100 may be electrically connected to a corresponding normal power adapter. It should be noted that, the fast charging function herein may refer to a charging state in which the charging current is greater than or equal to 2.5A, and the normal charging may refer to a charging state in which the charging current is less than 2.5A.

In some embodiments of the present disclosure, as shown in FIGS. 1 and 5 and 6, the power interface 100 may further include an encapsulation member 24, and the intermediate patch 23 and the plug body 2 may be wrapped by the encapsulation member 24. The encapsulation member 24 may be made of electrically insulative and heat-conductive material. The encapsulation member 24 may be configured to fix the intermediate patch 23, the power source pins 21 and the data pins 22 of the plug body 2, thereby ensuring the reliability of the connection between the connection line of the power adapter and the power interface 100. The encapsulation member 24 may include a first encapsulation portion 241 and a second encapsulation portion 242. The first encapsulation portion 241 and the second encapsulation portion 242 may match with and cooperate with each other. More specifically, the second encapsulation portion 242 may define a plurality of receiving groove 2421, and a plurality of embedding protrusions 2411 may be arranged on the first encapsulation portion 241. The plurality of receiving grooves 2421 may be in one-to-one correspondence with the plurality of embedding protrusions 2411, and cooperate with the plurality of embedding protrusions 2411. In this way, the reliability of the connection between the first encapsulation portion 241 and the second encapsulation portion 242 may be improved.

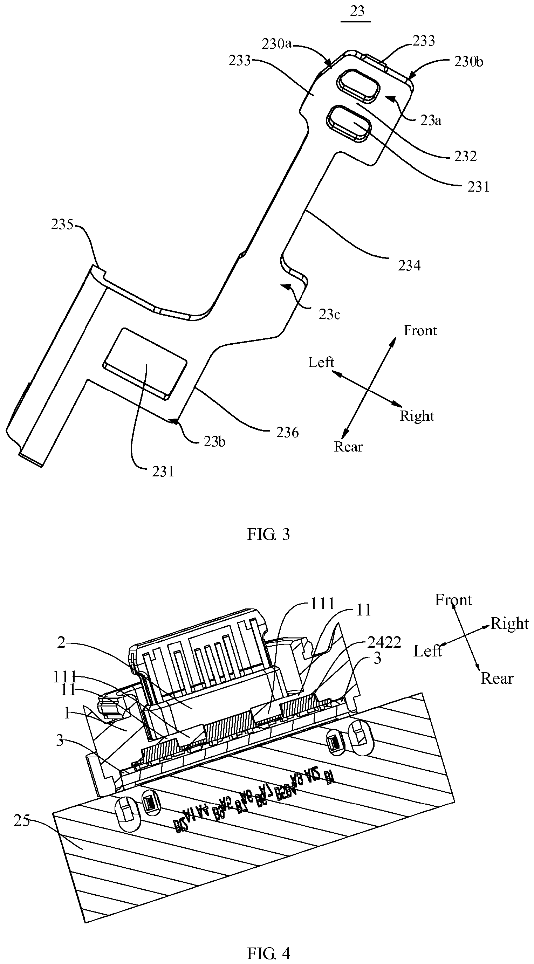

In some embodiments of the present disclosure, as shown in FIG. 3, the reinforcing rib 232 may extend in the left-right direction. In this way, the structural strength of the intermediate patch 23 may be enhanced. Of course, the present disclosure may not be limited thereto. For example, the reinforcing rib 232 may extend in the front-rear direction, or an extending direction of the reinforcing rib 232 may be at an angle to the left-right direction, as long as the structural strength of the intermediate patch 23 may be enhanced.

In some embodiments of the present disclosure, as shown in FIG. 3, a reinforcing protrusion 233 that protrudes away from the plug body 2 may be arranged at the head end. The reinforcing protrusion 233 may increase area of the contact face between the intermediate patch 23 and the encapsulation member 24, enhance the adhesion between the intermediate patch 23 and the encapsulation member 24, and make the connection between the intermediate patch 23 and the encapsulation member 24 more stable. In this way, the intermediate patch 23 and the plug body 2 may be better fixed together by the encapsulation member 24.

Alternatively, as shown in FIG. 3, the reinforcing protrusion 233 may be located on at least one of a side wall face and a front end face of the head end. For example, in the example shown in FIG. 3, the front end face of the head end may be provided with the reinforcing protrusion 233, and the left-side wall face of the head end may be also provided with the reinforcing protrusion 233. In this way, it is possible to increase the contact face between the intermediate patch 23 and the encapsulation member 24, enhance the adhesion between the intermediate patch 23 and the encapsulation member 24, and make the connection between the intermediate patch 23 and the encapsulation member 24 more stable. In this way, the intermediate patch 23 and the plug body 2 may be better fixed together by the encapsulation member 24.

As shown in FIG. 3, in order to increase the flexibility of the intermediate patch 23, a notch 234 may be defined in the middle of the intermediate patch 23. In this way, when the intermediate patch 23 is shifted upwardly or downwardly, the intermediate patch 23 may quickly return back to the original position due to the notch 234, which facilitates the connection between the connection line of the power adapter and the power interface 100 next time.

In some embodiments of the present disclosure, as shown in FIG. 3, a crimping 235 may be arranged at the tail end, and one of the pair of power source pins 21 may be configured to be wrapped by the crimping 235. On one hand, the crimping 235 may increase the contact face between the intermediate patch 23 and the encapsulation member 24, enhance the adhesion between the intermediate patch 23 and the encapsulation member 24, and make the connection between the intermediate patch 23 and the encapsulation member 24 more stable, thereby better fixing the intermediate patch 23 and the plug body 2 together by the encapsulation member 24. On the other hand, the crimping 235 may provide a protection to the power source pin 21.

In addition, as shown in FIG. 3, the tail end may also define a hollowed-out parts 231. In this way, it is possible to further save the material of the intermediate patch 23. Of course, in order to ensure the structural strength of the intermediate patch 23, a reinforcing rib 232 may also be arranged in the hollowed-out parts 231.

In some embodiments of the present disclosure, as shown in FIGs. 5 and 6, by spacing apart the tail end of the intermediate patch 23 from the plug shell 1 and connecting the tail end of the intermediate patch 23 to the plug body 2, it is possible to avoid producing interference with antenna signals, and thus the quality and the speed of signal transmission may be improved. In addition, both the tail end and the plug shell 1 may be connected to the plug body 2. In this way, the intermediate patch 23, the plug shell 1, and the plug body 2 may be connected to each other, thereby improving the reliability of the connection among the intermediate patch 23, the plug shell 1, and the plug body 2.

In some embodiments of the present disclosure, as shown in FIG. 1 and FIG. 5, a first pad 251 and a second pad 252 spaced apart from each other may be arranged on the circuit board 25 of the plug body 2. The plug shell 1 may be welded on the first pad 251, and the tail end may be welded on the second pad 252. In this way, the plug shell 1 and the intermediate patch 23 may be connected to the circuit board 25, thereby firmly fixing the plug body 2 to the circuit board 25 and preventing the power source pins 21 of the plug body 2 from falling off the circuit board 25, and thus the reliability of the operation of the power interface 100 may be ensured.

In some embodiments of the present disclosure, as shown in FIG. 4, FIG. 5, FIG. 7, and FIG. 8, a first stopping plate 11 may be arranged in the plug shell 1. An engaging flange 2422 may be arranged on the plug body 2. The power interface 100 may further include a second stopping plate 3. In this case, the second stopping plate 3 may be arranged in the plug shell 1, connected to the plug shell 1, and spaced apart from the first stopping plate 11. The engaging flange 2422 may be sandwiched between the first stopping plate 11 and the second stopping plate 3. In this way, the plug body 2 may be fixed in the plug shell 1 by the first stopping plate 11 and the second stopping plate 3, and the plug body 2 may be prevented from moving in the up-down direction of the plug shell 1 to prevent the plug body 2 from being separated from the plug shell 1. Therefore, when the connection line of the power adapter is inserted into the power interface 100, the reliability of the connection between the connection line and the power interface 100 may be improved.

In some embodiments, the plug shell 1 and the second stopping plate 3 may be made of metal, and the second stopping plate 3 may be welded on the plug shell 1. The plug shell 1 and the second stopping plate 3 made of metal may have a great structural strength. In this way, it is possible to enhance the structural strength of the power interface 100, and the power interface 100 may be prevented from being deformed after a long time of use or after frequent insertion and removal. In addition, since the inner space of the plug shell 1 is limited, when the second stopping plate 3 is welded on the plug shell 1, it is possible to simplify the processing and assembling processes, shorten manufacturing cycles, and reduce the manufacturing cost.

In some embodiments, the second stopping plate 3 may be made of stainless steel. In this way, it is possible to avoid the second stopping plate 3 from rusting, and thus the poor contact of the plug body 2 with the power adapter due to the rusting of the second stopping plate 3 may be prevented from occurring. Therefore, the reliability of the operation of the power interface 100 may be ensured.

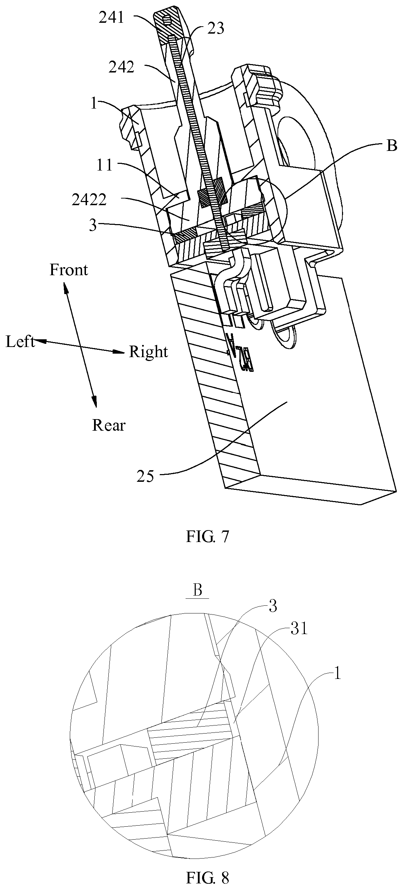

In some embodiments of the present disclosure, as shown in FIG. 8, a gap 31 may be defined between the second stopping plate 3 and the plug shell 1, and an adhesive layer may be arranged in the gap 31. On one hand, the adhesive layer may further bond the second stopping plate 3 with the plug shell 1, to improve the reliability of the connection between the second stopping plate 3 and the plug shell 1. On the other hand, the adhesive layer may have a waterproof function, that is, the adhesive layer may prevent liquid from entering the power interface 100 via an open end of the power interface 100 and damaging of the circuit board 25 inside the power interface 100, and the like, thereby ensuring the reliability of the power interface 100.

More specifically, the adhesive layer may be a dispensing layer. Dispensing is a process in which electronic glue, oil or other liquid may be applied to a product by means of painting, potting, or dripping, to allow the product to be adhesive, potted, insulated, fixed, and have a smooth face. On one hand, the dispensing layer may further bond the second stopping plate 3 with the plug shell 1 to improve the reliability of the connection between the second stopping plate 3 and the plug shell 1. On the other hand, the dispensing layer may have a waterproof function, that is, the dispensing layer may prevent liquid from entering the power interface 100 via an open end of the power interface 100 and damaging of the circuit board 25 inside the power interface 100, and the like, thereby ensuring the reliability of the power interface 100.

In some embodiments of the present disclosure, as shown in FIGS. 4-7, the second stopping plate 3 may extend in a circumferential direction of the plug body 2. On one hand, it is possible to improve the reliability of the connection between the second stopping plate 3 and the plug shell 1; on the other hand, it is also possible to enhance the fixing of the plug body 2 by the second stopping plate 3. In this way it is possible to ensure that the plug body 2 is securely fixed in the plug shell 1, and improve the reliability of the connection between a power line of the power adapter and the power interface 100.

In some embodiments, a plurality of second stopping plates 3 may be provided, thereby facilitating the processing of the second stopping plate 3. It should be noted that, the plurality of second stopping plates 3 may be spaced apart from each other along the circumferential direction of the plug shell 1, and the plurality of second stopping plates 3 may also form an annular stopping plate. The plurality of second stopping plates 3 may be respectively connected to the plug shell 1, in order to fix the plug body 2.

In some embodiments of the present disclosure, as shown in FIGS. 4-7, the first stopping plate 11 may also extend in the circumferential direction of the plug body 2. In this way, it is possible to enhance the fixing of the plug body 2 by the first stopping plate 11. In other embodiments, a stopping protrusion 111 may be arranged on a sidewall of the first stopping plate 11 that faces towards the second stopping plate 3, and the stopping protrusion 111 may be engaged with the engaging flange 2422. In this way, the first stopping plate 11 and the second stopping plate 3 may prevent the plug body 2 from moving in the up-down direction in the plug shell 1, and may also prevent the plug body 2 from shaking in the plug shell 1 by the cooperation between the engaging flange 2422 and the stopping protrusion 111, and thus it is possible to ensure the reliability of the operation of the power interface 100.

Referring to FIGS. 1-11, the power interface 100 according to embodiments of the present disclosure is described in details. It is noted that, the following description only is exemplary, and is not limitation to the present disclosure.

For convenience to describe, an example where the power interface 100 is implemented as a Type-C interface is described. The Type-C interface may also be called an USB Type-C interface. The Type-C interface belongs to a type of an interface, and is a new data, video, audio and power transmission interface specification developed and customized by the USB standardization organization to solve the drawbacks present for a long time that the physical interface specifications of the USB interface are uniform, and that the power can only be transmitted in one direction.

The Type-C interface may have the following features: a standard device may declare its willing to occupy a VBUS (that is, a positive connection wire of a traditional USB) to another device through a CC (Configuration Channel) pin in the interface specification. The device having a stronger willing may eventually output voltages and currents to the VBUS, while the other device may accept the power supplied from the VBUS bus, or the other device may still refuse to accept the power; however, it does not affect the transmission function. In order to use the definition of the bus more conveniently, a Type-C interface chip (such as LDR6013) may generally classify devices into four types: DFP (Downstream-facing Port), Strong DRP (Dual Role Power), DRP, and UFP (Upstream-facing Port). The willingness of these four types to occupy the VBUS bus may gradually decrease.

The DFP may correspond to an adapter, and may continuously output voltages to the VBUS. The Strong DRP may correspond to a mobile power, and may give up outputting voltages to the VBUS only when the strong DRP encounters the adapter. The DRP may correspond to a mobile phone. Normally, the DRP may expect other devices to supply power to itself. However, when encountering a device that may have a weaker willingness, the DRP may also output the voltages and currents to the device. The UFP will not output electrical power externally. Generally, the UFP is a weak battery device, or a device without any batteries, such as a Bluetooth headset. The USB Type-C interface may support the insertions both from a positive side and a negative side. Since there are four groups of power sources and grounds on both sides (the positive side and the negative side), the power supported by USB Type-C interface may be greatly improved.

The power interface 100 in this embodiment may be a USB Type-C interface, which may be applied to a power adapter with the fast charging function, or a normal power adapter. The fast charging herein may refer to a charging state in which a charging current is greater than 2.5A. The normal charging herein may refer to a charging state in which the charging current is less than or equal to 2.5A. That is, when the power interface 100 is charged by the power adapter with the fast charging function, the charging current is greater than or equal to 2.5A, or the rated output power is no less than 15W. When the power interface 100 is charged by the normal power adapter, the charging current is less than 2.5A, or the rated output power is less than 15W.

More specifically, as shown in FIGS. 1-8, the power interface 100 may include a plug shell 1, a plug body 2, a intermediate patch 23, and an encapsulation member 24. The plug body 2 may be arranged in the plug shell 1, configured to be connected to the circuit board 25, and may include four pairs of power source pins 21. Each pair of power source pins 21 may include two power source sub-pins 21 spaced apart from each other in the up-down direction. The intermediate patch 23 may be sandwiched between the two power source sub-pins 211, such that it is possible to avoid poor contact between the connecting line and the power interface 100 caused by the movement of the two power source sub-pins 211 which are spaced apart from each other in the up-down direction towards each other. The intermediate patch 23 and the plug body 2 may be wrapped by the encapsulation member 24.

In this case, the encapsulation member 24 may be made of electrically insulative and heat-conductive material. The encapsulation member 24 may be configured to fix the intermediate patch 23, the power source pins 21 and the data pins 22 of the plug body 2, thereby ensuring the reliability of the connection between the connection line of the power adapter and the power interface 100. As shown in FIGS. 1, 5 and 6, the encapsulation member 24 may include a first encapsulation portion 241 and a second encapsulation portion 242. The second encapsulation portion 242 may define a plurality of receiving groove 2421, and the first encapsulation portion 241 may include a plurality of embedding protrusions 2411. The plurality of receiving grooves 2421 may be in one-to-one correspondence with the plurality of embedding protrusions 2411, and cooperate with the plurality of embedding protrusions 2411. In this way, the reliability of the connection between the first encapsulation portion 241 and the second encapsulation portion 242 may be improved.

As shown in FIG. 3, the intermediate patch 23 may have a head end close to a front end of the power source pin 21 and a tail end close to a rear end of the power source pin 21. The head end may define a hollowed-out parts 231, and a reinforcing rib 232 may be arranged in the hollowed-out parts 231. The reinforcing rib 232 may extend in the left-right direction. In this way, the material of the intermediate patch 23 may be saved, and the structural strength of the intermediate patch 23 may be enhanced. The head end and the left-side wall face may have a reinforcing protrusion 233 that protrudes away from the plug body 2. The reinforcing protrusion 233 may increase the area of the contact face between the intermediate patch 23 and the encapsulation member 24, enhance the adhesion between the intermediate patch 23 and the encapsulation member 24, and make the connection between the intermediate patch 23 and the encapsulation member 24 more stable. In this way, the intermediate patch 23 and the plug body 2 may be better fixed together by the encapsulation member 24.

As shown in FIG. 3, a notch 234 may be defined in the middle of the intermediate patch 23. In this way, when the intermediate patch 23 is shifted upwardly or downwardly, the intermediate patch 23 may quickly return back to the original position. A crimping 235 may be arranged at the tail end, and one of the pair of power source pins 21 may be wrapped by the crimping 235. The crimping 235 may increase the contact face between the intermediate patch 23 and the encapsulation member 24, and provide a protection to the power source pin 21. The tail end may have a widened portion 236, and the widened portion 236 may define a hollowed-out parts 231, which further saves the material of the intermediate patch 23.

In addition, as shown in FIG. 1, FIG. 5 and FIG. 6, the tail end may be spaced apart from the plug shell 1 and connected to the plug body 2. In this way, it is possible to avoid producing interference with the antenna signals, and thus the quality and the speed of signal transmission may be improved. A first pad 251 and a second pad 252 spaced apart from each other may be arranged on the circuit board 25 of the plug body 2. The plug shell 1 may be welded on the first pad 251, and the tail end 23b may be welded on the second pad 252. In this way, the plug shell 1 and the intermediate patch 23 may be connected to the circuit board 25, thereby firmly fixing the plug body 2 to the circuit board 25 and preventing the power source pins 211 of the plug body 2 from falling off the circuit board 25, and thus the reliability of the operation of the power interface 100 may be ensured.

As shown in FIG. 2, at least one sub-pin 211 may include an expanded portion 2111. The expanded portion 2111 may have a cross-sectional area larger than that of a data pin 22 of the plug body 2. In this way, the current load of the power source sub-pins 211 may be increased, and the transmission speed of the current may be improved. A recess 2112 may be defined in the expanded portion 2111 at a position that is close to the front end of the sub-pin 211. When the power interface 100 performs the fast charging function, the sub-pin 211 with the expanded portion 2111 may be used to carry a large charging current. When the power interface 100 performs the normal charging function, the recess 2112 on the expanded portion 2111 may prevent the sub-pin 211 from getting into contact with a corresponding pin of a power adapter.

In this case, as shown in FIG. 11, a thickness of the sub-pin 211 may be defined as D, and the cross-sectional area of the expanded portion 2111 may be defined as S. It has been experimentally verified that, when D=0.25 mm and S=0.13125 mm², the current load of the power source sub-pins 211 is at least 12A, thereby improving the charging efficiency. Furthermore, as shown in FIG. 11, when W = 0.25 mm, the current load of the power source sub-pins 211 is at least 14A, thereby improving the charging efficiency.

Furthermore, as shown in FIGS. 4-8, a first stopping plate 11 may be arranged in the plug shell 1, and an engaging flange 2422 may be arranged on the second encapsulation portion 242. The power interface 100 may further include a second stopping plate 3. The second stopping plate 3 may be arranged in the plug shell 1, connected to the plug shell 1, and spaced apart from the first stopping plate 11. The engaging flange 2422 may be sandwiched between the first stopping plate 11 and the second stopping plate 3. In this way, the second encapsulation portion 242 may be fixed in the plug shell 1 by the first stopping plate 11 and the second stopping plate 3, thereby fixing the plug body 2 in the plug shell 1, and preventing the plug body 2 from moving in the up-down direction of the plug shell 1.

In this case, the first stopping plate 11 and the second stopping plate 3 may be made of metal, and the second stopping plate 3 may be made of stainless steel. The second stopping plate 3 may be connected to the plug shell 1 by means of spot welding. The plug shell 1 and the second stopping plate 3 made of metal may have a great structural strength. In this way, it is possible to enhance the structural strength of the power interface 100. In addition, since the inner space of the plug shell 1 is limited, when the second stopping plate 3 is welded on the plug shell 1, it is possible to simplify the processing and assembling processes, shorten manufacturing cycles, and reduce the manufacturing cost. A gap 31 may be defined between the second stopping plate 3 and the plug shell 1, and a dispensing layer may be arranged in the gap 31. On one hand, the dispensing layer may further bond the second stopping plate 3 with the plug shell 1 to improve the reliability of the connection between the second stopping plate 3 and the plug shell 1. On the other hand, the dispensing layer may have a waterproof function; that is, the dispensing layer may prevent liquid from entering the power interface 100 via an open end of the power interface 100 and damaging of the circuit board 25 inside the power interface 100, and the like, thereby ensuring the reliability of the power interface 100. In this embodiment, a pair of second stopping plates 3 may be provided. The pair of second stopping plates 3 may extend in the circumferential direction of the plug shell 1. The pair of second stopping plates 3 may form an annular stopping plate. In this way, the reliability of the connection between the second stopping plate 3 and the plug shell 1 may be enhanced, and the structure of the second stopping plate 3 may be simplified.

The first stopping plate 11 may also extend in the circumferential direction of the plug body 2. In this way, it is possible to enhance the fixing of the plug body 2 by the first stopping plate 11. A stopping protrusion 111 may be arranged on a sidewall face of the first stopping plate 11 that faces towards the second stopping plate 3, and the stopping protrusion 111 may be engaged with engaging groove 2423 between two adjacent engaging flanges 2422. In this way, it is possible to prevent the plug body 2 from shaking in the plug shell 1 by the cooperation between the engaging flange 2422 and the stopping protrusion 111, and thus it is possible to ensure the reliability of the operation of the power interface 100.

A method for manufacturing the power interface 100 according to an embodiment of the present disclosure will now be described with reference to FIGS. 1-11. Herein, the power interface 100 may be the power interface 100 described above.

The method for manufacturing the power interface 100 according to an embodiment of the present disclosure may include operations at the following blocks.

At block S10: the plug shell 1 may be processed.

At block S20: the plug body 2 may be mounted into the plug shell 1.

At block S30: the second stopping plate 3 may be welded on an inner wall of the plug shell 1.

According to the method for manufacturing the power interface 100 of the embodiment of the present disclosure, the plug body 2 may be fixed in the plug shell 1, thereby ensuring the reliability of the operation of the power interface 100.

The plug shell 1 at the block S10 may be an injection molded part, and the first stopping plate 11 may be injected on the inner wall of the plug shell 1, which may facilitate the processing of the plug shell 1 and the first stopping plate 11. At the block S30, the second stopping plate 3 may be connected to the plug shell 1 by means of spot welding. The spot welding may be a quick and economical connection method in which the weldments may be welded to each other on the contact face at the joint between the weldments by individual welding spots.

Furthermore, a gap 31 may be defined between the second stopping plate 3 and the plug shell 1. The method for manufacturing the power interface 100 may further include: arranging an adhesive layer in the gap 31, such that the second stopping plate 3 and the plug shell 1 may be closely bonded with each other, and liquid may be prevent from entering the power interface 100.

A mobile terminal according to an embodiment of the present disclosure may include the power interface 100 as described above. The mobile terminal may realize the transmission of electrical signals and data signals via the power interface 100. For example, the mobile terminal may be electrically connected to the power adapter through the power interface 100 to implement a charging or data transmission function.

In the power interface 100 of the embodiment of the present disclosure, by arranging the intermediate patch 23 between the pair of power source pins 211 which are spaced apart from each other in the up-down direction, it is possible to support the power source pins 211, and avoid poor contact between a connecting line and the power interface 100 caused by the movement of the pair of power source pins 211 which are spaced apart from each other in the up-down direction towards each other when the connection line is inserted into the power interface. In this way, it is possible to ensure the reliability of the connection between the connection line and the power interface 100. In addition, the intermediate patch 23 defines the hollowed-out parts 231 and the reinforcing rib 232 arranged in the hollowed-out parts 231 could not only save the material of the intermediate patch 23, but also improve the structural strength of the intermediate patch 23.

A power adapter according to an embodiment of the present disclosure may include the power interface 100 as described above. The mobile terminal may realize the transmission of electrical signals and data signals via the power interface 100.

The power adapter according to an embodiment of the present disclosure, by spacing apart the tail end of the intermediate patch 23 from the plug shell 1 and connecting the tail end of the intermediate patch 23 to the plug body 2, it is possible to avoid producing interference with antenna signals, and thus the quality and the speed of signal transmission may be improved. In addition, both the tail end and the plug shell 1 may be connected to the plug body 2. In this way, the intermediate patch 23, the plug shell 1, and the plug body 2 may be connected to each other, thereby improving the reliability of the connection among the intermediate patch 23, the plug shell 1, and the plug body 2.

Reference throughout this specification, the reference terms "an embodiment", "some embodiments", "an example", "a specific example", or "some examples", and the like means that a specific feature, structure, material, or characteristic described in connection with the embodiment or example is included in at least one embodiment or example of the present disclosure. Thus, the illustrative descriptions of the terms throughout this specification are not necessarily referring to the same embodiment or example of the present disclosure.

Although explanatory embodiments have been shown and described, it would be appreciated by one skilled in the art that the above embodiments previously described are illustrative, and cannot be construed to limit the present disclosure. Changes, alternatives, and modifications can be made in the embodiments without departing from scope of the claims.

## Claims

1. A power interface, **characterized by** comprising:
a plug shell (1);
a plug body (2), arranged in the plug shell (1), configured to be connected to a circuit board (25), and comprising at least one power-pin assembly (21); wherein each of the at least one power-pin assembly (21) comprises a pair of power pins (211) spaced apart from each other in a first direction; and
an intermediate patch (23), sandwiched between the pair of power pins (211), extending along a second direction perpendicular to the first direction, and comprising a tail end (23b) connected to the circuit board (25) and a head end (23a) away from the circuit board (25) and opposite to the tail end in the second direction; wherein the head end defines a through hole (231) and has a reinforcing rib (232) arranged in the through hole (231);
wherein the plug body (2) further comprises a data pin (22), at least one of the pair of power pins (211) comprises an expanded portion (2111), and the expanded portion (2111) has a cross-sectional area larger than that of the data pin (22) of the plug body (2) to increase a current load of the at least one of the pair of power pins (211); and
wherein an end of each of the pair of power pins (211) is connected to the circuit board (25), and a recess (2112) is defined in the expanded portion (2111) at a position away from the circuit board (25).

2. The power interface of claim 1, wherein the reinforcing rib (232) comprises a first end and a second end opposite to the first end, both the first end and the second end are connected to the intermediate patch (23), and an extending direction from the first end to the second end is perpendicular to the first and second direction.

3. The power interface of claim 1, wherein the reinforcing rib (232) comprises a first end and a second end opposite to the first end, both the first end and the second end are connected to the intermediate patch (23), and an extending direction from the first end to the second end is the second direction.

4. The power interface of claim 1, wherein the reinforcing rib (232) comprises a first end and a second end opposite to the first end, both the first end and the second end are connected to the intermediate patch (23), and an extending direction from the first end to the second end forms an angle with a third direction perpendicular to the first and second direction.

5. The power interface of any one of claims 1 to 4, wherein a reinforcing protrusion (233) protrudes from an outer face of the head end in a direction away from a center of the power interface (100).

6. The power interface of any one of claims 1 to 5, wherein the intermediate patch (23) comprises a connection portion connected between the head end and the tail end; a notch (234) is defined in the connection portion.

7. The power interface of any one of claims 1 to 6, wherein a crimping (235) is arranged at the tail end, and the crimping (235) is bent in a direction towards one of the pair of power pins (211).

8. The power interface of any one of claims 1 to 7, further comprising an encapsulation member (24), wherein the intermediate patch (23) and the plug body (2) are wrapped by the encapsulation member (24).

9. The power interface of claim 8, wherein the encapsulation member (24) is made of electrically insulative and heat-conductive material.

10. The power interface of claims 8 or 9, wherein the encapsulation member (24) comprises a first encapsulation portion (241) and a second encapsulation portion (242) connected to the first encapsulation portion (241); the second encapsulation portion (242) defines a plurality of receiving groove (2421), and a plurality of embedding protrusions (2411) are arranged on the first encapsulation portion (241); the plurality of receiving grooves (2421) are in one-to-one correspondence with the plurality of embedding protrusions (2411).

11. The power interface of claim 1, wherein the expanded portion (2111) is located in the middle part of the at least one of the pair of power pins (211).

12. A mobile terminal, comprising the power interface (211) of any one of claims 1-11.

13. A power adapter, comprising the power interface (211) of any one of claims 1-11.

## Patentansprüche

1. Leistungsschnittstelle, die **dadurch gekennzeichnet ist, dass** sie Folgendes umfasst:
eine Steckerschale (1);
einen Steckerkörper (2), der in der Steckerschale (1) angeordnet ist, dazu ausgelegt ist, mit einer Leiterplatte (25) verbunden zu werden, und mindestens eine Leistungsstiftanordnung (21) umfasst; wobei jede der mindestens einen Leistungsstiftanordnung (21) ein Paar von Leistungsstiften (211) umfasst, die in einer ersten Richtung voneinander beabstandet sind; und
einen Zwischenverteiler (23), der zwischen dem Paar von Leistungsstiften (211) eingesetzt ist, sich entlang einer zweiten Richtung senkrecht zur ersten Richtung erstreckt und ein hinteres Ende (23b), das mit der Leiterplatte (25) verbunden ist, und ein vorderes Ende (23a), das in der zweiten Richtung von der Leiterplatte (25) entfernt ist und dem hinteren Ende gegenüberliegt, umfasst; wobei das vordere Ende ein Durchgangsloch (231) definiert und eine Verstärkungsrippe (232) aufweist, die im Durchgangsloch (231) angeordnet ist;
wobei der Steckerkörper (2) ferner einen Datenstift (22) umfasst, mindestens einer des Paares von Leistungsstiften (211) einen erweiterten Abschnitt (2111) umfasst und der erweiterte Abschnitt (2111) eine Querschnittsfläche aufweist, die größer ist als die des Datenstifts (22) des Steckerkörpers (2), um die Stromlast des mindestens einen des Paares von Leistungsstiften (211) zu erhöhen; und
wobei ein Ende von jedem des Paares von Leistungsstiften (211) mit der Leiterplatte (25) verbunden ist und im erweiterten Abschnitt (2111) in einer Position, die von der Leiterplatte (25) entfernt ist, eine Ausnehmung (2112) definiert ist.

2. Leistungsschnittstelle nach Anspruch 1, wobei die Verstärkungsrippe (232) ein erstes Ende und ein zweites Ende gegenüber dem ersten Ende umfasst, beide des ersten Endes und des zweiten Endes mit dem Zwischenverteiler (23) verbunden sind und eine Erstreckungsrichtung vom ersten Ende zum zweiten Ende senkrecht zur ersten und zur zweiten Richtung verläuft.

3. Leistungsschnittstelle nach Anspruch 1, wobei die Verstärkungsrippe (232) ein erstes Ende und ein zweites Ende gegenüber dem ersten Ende umfasst, beide des ersten Endes und des zweiten Endes mit dem Zwischenverteiler (23) verbunden sind und eine Erstreckungsrichtung vom ersten Ende zum zweiten Ende die zweite Richtung ist.

4. Leistungsschnittstelle nach Anspruch 1, wobei die Verstärkungsrippe (232) ein erstes Ende und ein zweites Ende gegenüber dem ersten Ende umfasst, beide des ersten Endes und des zweiten Endes mit dem Zwischenverteiler (23) verbunden sind und eine Erstreckungsrichtung vom ersten Ende zum zweiten Ende einen Winkel mit einer dritten Richtung senkrecht zur ersten und zur zweiten Richtung bildet.

5. Leistungsschnittstelle nach einem der Ansprüche 1 bis 4, wobei ein Verstärkungsvorsprung (233) von einer Außenseite des vorderen Endes in eine Richtung von einer Mitte der Leistungsschnittstelle (100) weg vorsteht.

6. Leistungsschnittstelle nach einem der Ansprüche 1 bis 5, wobei der Zwischenverteiler (23) einen Verbindungsabschnitt umfasst, der zwischen dem vorderen Ende und dem hinteren Ende verbunden ist; im Verbindungsabschnitt eine Kerbe (234) definiert ist.

7. Leistungsschnittstelle nach einem der Ansprüche 1 bis 6, wobei am hinteren Ende eine Crimpung (235) angeordnet ist und die Crimpung (235) in eine Richtung zu einem des Paares von Leistungsstiften (211) gebogen ist.

8. Leistungsschnittstelle nach einem der Ansprüche 1 bis 7, die ferner ein Kapselungselement (24) umfasst, wobei der Zwischenverteiler (23) und der Steckerkörper (2) vom Kapselungselement (24) umhüllt sind.

9. Leistungsschnittstelle nach Anspruch 8, wobei das Kapselungselement (24) aus einem elektrisch isolierenden und wärmeleitenden Material besteht.

10. Leistungsschnittstelle nach Anspruch 8 oder 9, wobei das Kapselungselement (24) einen ersten Kapselungsabschnitt (241) und einen zweiten Kapselungsabschnitt (242), der mit dem ersten Kapselungsabschnitt (241) verbunden ist, umfasst; der zweite Kapselungsabschnitt (242) eine Vielzahl von Aufnahmenuten (2421) umfasst, und eine Vielzahl von Einbettungsvorsprüngen (2411) im ersten Kapselungsabschnitt (241) angeordnet sind; die Vielzahl von Aufnahmenuten (2421) eine Eins-zu-eins-Entsprechung mit der Vielzahl von Einbettungsvorsprüngen (2411) aufweisen.

11. Leistungsschnittstelle nach Anspruch 1, wobei sich der erweiterte Abschnitt (2111) im mittleren Teil des mindestens einen des Paares von Leistungsstiften (211) befindet.

12. Mobiles Endgerät, das die Leistungsschnittstelle (211) nach einem der Ansprüche 1-11 umfasst.

13. Netzteil, das die Leistungsschnittstelle (211) nach einem der Ansprüche 1-11 umfasst.

## Revendications

1. Interface d'alimentation, **caractérisée en ce qu'**elle comprend :
une coque de fiche (1) ;
un corps de fiche (2), agencé dans la coque de fiche (1), configuré pour être connecté à une carte de circuit imprimé (25), et comprenant au moins un ensemble de broches d'alimentation (21) ; chacun des au moins un ensemble de broches d'alimentation (21) comprenant une paire de broches d'alimentation (211) espacées l'une de l'autre dans une première direction ; et
une pièce intermédiaire (23), prise en sandwich entre la paire de broches d'alimentation (211), s'étendant le long d'une deuxième direction perpendiculaire à la première direction, et comprenant une extrémité de queue (23b) connectée à la carte de circuit imprimé (25) et une extrémité de tête (23a) éloignée de la carte de circuit imprimé (25) et opposée à l'extrémité de queue dans la deuxième direction ; l'extrémité de tête définissant un trou traversant (231) et ayant une nervure de renforcement (232) agencée dans le trou traversant (231) ;
le corps de fiche (2) comprenant en outre une broche de données (22), au moins une de la paire de broches d'alimentation (211) comprenant une partie élargie (2111), et la partie élargie (2111) ayant une zone de section transversale plus grande que celle de la broche de données (22) du corps de fiche (2) pour augmenter une charge de courant de l'au moins une de la paire de broches d'alimentation (211) ; et
une extrémité de chacune de la paire de broches d'alimentation (211) étant connectée à la carte de circuit imprimé (25), et un évidement (2112) étant défini dans la partie élargie (2111) à une position éloignée de la carte de circuit imprimé (25).

2. Interface d'alimentation selon la revendication 1, la nervure de renforcement (232) comprenant une première extrémité et une seconde extrémité opposée à la première extrémité, la première extrémité et la seconde extrémité étant toutes deux connectées à la pièce intermédiaire (23), et une direction d'extension de la première extrémité à la seconde extrémité étant perpendiculaire aux première et deuxième directions.

3. Interface d'alimentation selon la revendication 1, la nervure de renforcement (232) comprenant une première extrémité et une seconde extrémité opposée à la première extrémité, la première extrémité et la seconde extrémité étant toutes deux connectées à la pièce intermédiaire (23), et une direction d'extension de la première extrémité à la seconde extrémité étant la deuxième direction.

4. Interface d'alimentation selon la revendication 1, la nervure de renforcement (232) comprenant une première extrémité et une seconde extrémité opposée à la première extrémité, la première extrémité et la seconde extrémité étant toutes deux connectées à la pièce intermédiaire (23), et une direction d'extension de la première extrémité à la seconde extrémité formant un angle avec une troisième direction perpendiculaire aux première et deuxième directions.

5. Interface d'alimentation selon l'une quelconque des revendications 1 à 4, une saillie de renforcement (233) faisant saillie à partir d'une face extérieure de l'extrémité de tête dans une direction s'éloignant d'un centre de l'interface d'alimentation (100).

6. Interface d'alimentation selon l'une quelconque des revendications 1 à 5, la pièce intermédiaire (23) comprenant une partie de connexion connectée entre l'extrémité de tête et l'extrémité de queue ;
une encoche (234) étant définie dans la partie de connexion.

7. Interface d'alimentation selon l'une quelconque des revendications 1 à 6, un sertissage (235) étant agencé à l'extrémité de queue, et le sertissage (235) étant plié dans une direction vers l'une de la paire de broches d'alimentation (211).

8. Interface d'alimentation selon l'une quelconque des revendications 1 à 7, comprenant en outre un élément d'encapsulation (24), la pièce intermédiaire (23) et le corps de fiche (2) étant enveloppés par l'élément d'encapsulation (24).

9. Interface d'alimentation selon la revendication 8, l'élément d'encapsulation (24) étant constitué d'un matériau électriquement isolant et thermoconducteur.

10. Interface d'alimentation selon la revendication 8 ou 9, l'élément d'encapsulation (24) comprenant une première partie d'encapsulation (241) et une seconde partie d'encapsulation (242) connectée à la première partie d'encapsulation (241) ; la seconde partie d'encapsulation (242) définissant une pluralité de rainures de réception (2421), et une pluralité de saillies d'encastrement (2411) étant agencées sur la première partie d'encapsulation (241) ; la pluralité de rainures de réception (2421) étant en correspondance une à une avec la pluralité de saillies d'encastrement (2411) .

11. Interface d'alimentation selon la revendication 1, la partie élargie (2111) étant située dans la partie centrale de l'au moins une de la paire de broches d'alimentation (211).

12. Terminal mobile, comprenant l'interface d'alimentation (211) selon l'une quelconque des revendications 1 à 11.

13. Adaptateur d'alimentation, comprenant l'interface d'alimentation (211) selon l'une quelconque des revendications 1 à 11.
